(19) **Europäisches Patentamt**

**European Patent Office**

**Office européen des brevets**

(11)  **EP 1 278 311 A2**

(12)  **EUROPEAN PATENT APPLICATION**

(43) Date of publication:
**22.01.2003 Bulletin 2003/04**

(51) Int Cl.⁷: **H04B 7/185**

(21) Application number: **02102044.1**

(22) Date of filing: **19.07.2002**

| | |
|---|---|
| (84) Designated Contracting States:<br>**AT BE BG CH CY CZ DE DK EE ES FI FR GB GR IE IT LI LU MC NL PT SE SK TR**<br>Designated Extension States:<br>**AL LT LV MK RO SI** | (72) Inventors:<br> • **Haugli, Hans**<br>  **Ottawa, Ontario K1M 0S9 (CA)**<br> • **Houtman, Tom**<br>  **Ottawa, Ontario K1H 6G9 (CA)** |
| (30) Priority: **19.07.2001 US 306165 P** | (74) Representative: **Harding, Richard Patrick**<br>**Marks & Clerk,**<br>**4220 Nash Court**<br>**Oxford Business Park South**<br>**Oxford OX4 2RU (GB)** |
| (71) Applicant: **Vistar Telecommunications Inc.**<br>**Ottawa, Ontario K1R 7Y2 (CA)** | |

(54) **Method of improving efficiency in a satellite communications system.**

(57)    Disclosed is an apparatus for improving efficiency in a two-way wireless digital communications system. A predictor predicts the quality of a return link from a remote terminal to a central station from one or more parameters known at the remote terminal. A processor determines an appropriate transmission characteristic for said return link based on said predicted quality. An adjustor adjusts an actual transmission characteristic of said return link to match said appropriate transmission characteristic.

**FIG. 1**

**Description**

This invention relates to the field of satellite communications, and in particular to a method for improving efficiency in a satellite messaging system operative to provide communications between a mobile terminal and a fixed ground station.

Satellites in a geosynchronous orbit, located approximately 22,000 miles above the equator, may be used to provide one-way or two-way communications with a widely dispersed remote terminal population, some of which may be affixed to mobile assets. Communications transmissions from a central hub via satellite to the remote terminals are referred to as the forward link, while communications transmissions from the remote terminals via satellite to a central hub are referred to as the return link.

The return link throughput and required terminal transmit power are typically determined by a worst-case link budget which provides sufficient signal-to-noise ratio from remote terminals at the edge of the coverage area. Alternatively, terminals may be transmitting at a higher power than necessary for the actual signal-to-noise ration, thereby reducing the overall terminal capacity of the system.

Disclosed is a method of improving the efficiency of a satellite communications system by adjusting transmission characteristics in a predictive manner.

In one aspect of the present invention, an open loop predictive approach of determining the satellite link parameters is utilized, based on the approximate geographic position of the terminal. The major predictable components of link variability can be computed or read from a look-up table. In this way, the throughput can be increased without a feedback lag and can be applied to a single burst transmission.

With approximate knowledge of the terminal's position, the elevation angle from the terminal to the satellite can be computed or looked up in a look-up table. For mobile terminals, the transmit antenna gain is often strongly variable with elevation angle. Also based on the position, the satellite spot beam antenna gain can be determined. Optionally, the terminal transmit power variation with temperature and frequency can be estimated, and factory calibration of the transmit power, frequency and aging effects on power can be determined. Based on this aggregated information, the return link margin can be estimated. Alternatively, if only position-based variability is considered, a link geographic zone can be selected based on position alone.

Once the margin is estimated or a geographic zone is selected, it may be used to select one of a discrete group of possible link forward error correcting codes which are compatible with the design error rate at each of a discrete set of margins. The return link information is encoded using the chosen code, and the coded bits are then modulated and transmitted to the central hub. At the central hub, the type of forward error correction code and modulation scheme employed by the terminal is determined, and the encoded data is decoded.

Alternatively, the transmit power of the terminal can be adjusted to take into account terminal position. The transmitted power can reduced to a value that just provides sufficient signal-to-noise ratio for the desired effective transmission rate so as to optimize system capacity.

In another aspect, the present invention utilizes a closed loop predictive approach to adjust various transmission characteristics to improve the power and/or rate of transmission.

The two-way satellite communications system comprises an apparatus for improving the communications efficiency. The apparatus comprises a predictor for predicting the quality of a return link from a remote terminal to a central station from one or more parameters known at the remote terminal. A processor determines an appropriate transmission characteristic for said return link based on said predicted quality, and an adjustor adjusts an actual transmission characteristic of said return link to match said appropriate transmission characteristic.

In another aspect, the invention provides method of improving efficiency in a satellite communications system. The method comprises the steps of predicting the quality of a return link from a remote terminal to a central station from one or more parameters known at the remote terminal, determining an appropriate transmission characteristic for said return link based on said predicted quality, and adjusting an actual transmission characteristic of said return link to match said appropriate transmission characteristic.

Power control can make the received signal strengths of the geographically distributed terminals equal to that at edge of coverage. Edge of coverage may be defined as the intersection of the 0 dB/K satellite G/T contour and the 20° elevation contour. The 0 dB/K reference is incorporated by referencing the satellite G/T contours to 0 dB/K. The 20° elevation reference is incorporated by referencing the satellite range compensation and terminal antenna gain to that at 20° elevation.

Power control enables the system capacity to be maximized. As such, it can improve the statistical characteristics across the system by reducing the variance of received power at the earthstation.

Power control normally only has a noticeable effect when capacity is near its limit. Therefore, terminals newly released into the field when power control becomes significant can only constitute a small portion of the total terminal population on the channel, and their effect on the power distribution should be limited.

Other aspects and advantages of embodiments of the invention will be readily apparent to those ordinarily skilled in the art upon a review of the following description.

Embodiments of the invention will now be described in conjunction with the accompanying drawings, wherein:

Figure 1 illustrates a basic communication system with which the present invention maybe used;
Figure 2 is a flow chart illustrating a method of rate adaptation according to one embodiment of the present invention;
Figure 3 illustrates a punctured turbo code packet error rate versus code rate;
Figure 4 is a flow chart illustrating a method of rate adaptation according to another embodiment of the present invention;
Figure 5 multiple spot beam return link contours;
Figure 6 illustrates another method of an open loop implementation of the present invention;
Figure 7 illustrates one possible method of determining terminal position compensation for the method of Figure 6;
Figure 8 illustrates one possible method of determining satellite elevation angle for the method of Figure 6; and
Figure 9 is a block diagram of an exemplary implementation of the invention.

This invention will now be described in detail with respect to certain specific representative embodiments thereof, the materials, apparatus and process steps being understood as examples that are intended to be illustrative only. In particular, the invention is not intended to be limited to the methods, materials, conditions, process parameters, apparatus and the like specifically recited herein.

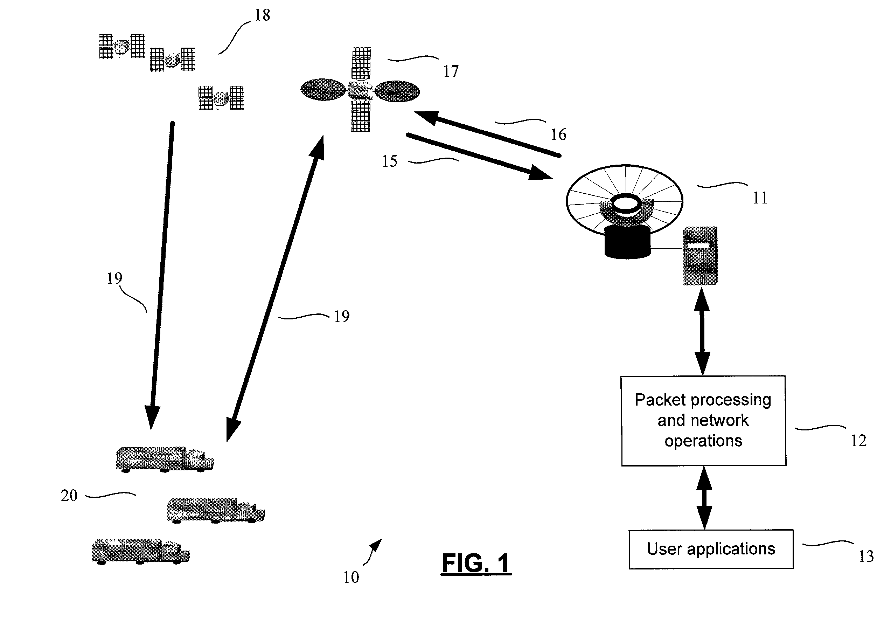

The present invention comprises a method for improving the efficiency of return link data signals. The present invention may be used in conjunction with a variety of communication systems, an exemplary embodiment of such a system is illustrated in Figure 1. In this embodiment, the satellite communications system 10 consists of a central Earth station 11 which is connected to packet processing and network operations center (PPC) 12, which communicates with various user applications 13.

The Earth station 11 is also coupled by satellite links 15, 16 to a geostationary multibeam satellite 17 and GPS constellations 18 which relays the signals via links 19 to and from a plurality of remote terminals 20, typically mounted on vehicles, such as helicopters, truck trailers, passenger cars, and rail cars. The satellite 18 permits coverage over a wide geographical area.

The satellite communications link 16, 19, which originates at the Earth station 11 and is relayed through a satellite 17, to the terminals 20, is referred to as the forward link. The satellite communications link 19, 15 which originates at the terminals 20 and is relayed through a satellite 17 to the Earth station 11, is referred to as the return link. Those skilled in the art will acknowledge that the key elements of the present invention pertain to mobile as well as fixed terminals, and to satellites in non-geostationary orbits.

The two-way wireless communications system comprises an apparatus for improving the communications efficiency. The apparatus comprises a predictor for predicting the quality of a return link from a remote terminal to a central station from one or more parameters known at the remote terminal, a processor for determining an appropriate transmission characteristic for said return link based on said predicted quality, and an adjustor for adjusting an actual transmission characteristic of said return link to match said appropriate transmission characteristic.

In one aspect, a rate adaptation method is employed, whereby for each transmission the mobile terminal will transmit at the maximum rate which will result in an acceptable C/No (carrier/noise) density on the return link. This is primarily an open loop predictive method based on knowledge of the power zone calculated and defined as above. In this case the "power zone" represents the gain of the receive antenna in the satellite. This will be more responsive to mobile units in the central region of its catchment area than near its periphery. By knowing the power zone, and minor influences like the PA (Power amplifier) power available in the MT (mobile terminal) as a function of temperature, at any point in time the MT can calculate the resulting C/No density for the return link.

Using a constant channel rate, the forward error correction (FEC) rate is selected as a function of the power zone, in order to ensure the minimum necessary return link C/No. This in turn will vary the resulting effective information rate. The worse the C/No ratio, the more redundant bits will be required in the forward error corrector. The addition of redundant bits reduces the effective information rate. By assuming the worst case scenario the system typically operates at reduced efficiency since more redundant bits are included in the forward error corrector than are required in the central portion of the coverage zone.

As an example, for the planned GlobalWave™ message channel for North American use, the FEC employs hypercode, with the typical result that for an MT at beam centre the hypercode (FEC) could be .75 (info bits / total bits), and at edge of coverage it could be typically .22, for a median value of .45. This would correspond to an adaptive information rate varying between 1.3 kbps and 4.5 kbps, with an average throughput of about 2.7 kbps. A classical system would have remained at 1.3 kbps all of the time to allow for the worst case scenario, which only arises at the periphery of the coverage zone.

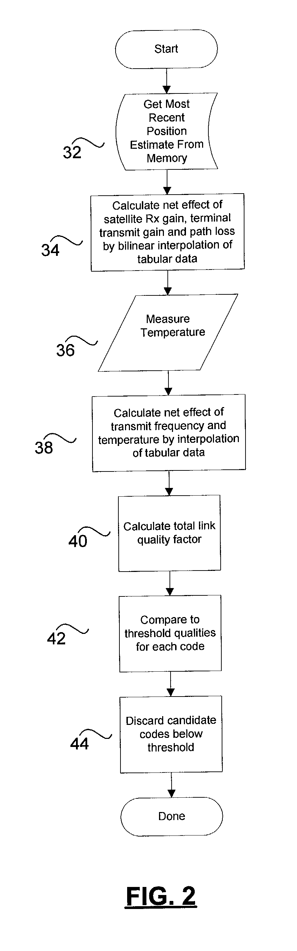

Figure 2 illustrates a flowchart for a remote terminal's method for rate adaptation for one embodiment of the invention. In this method, the terminal contains a first table of the position dependencies of transmit power in decibels for each beam, parameterized by latitude and longitude. This table contains the net effect of the satellite receive gain or G/T, path loss and mean terminal transmit antenna gain. A second table contains the temperature and frequency dependency of transmit power, also in decibels. The selection of base level (0 dB) for both of these tables may be made on the basis of convenience. In step 32, the most recent position estimate is retrieved from memory. In step 34, the net effect of satellite Rx gain, terminal gain and path loss is calculated by bilinear interpolation of the tabular data. In step 36, the temperature is measured. In step 38, the terminal computes a value from the first table for its most recent estimated position using bilinear interpolation. Also in step 38, the terminal then computes a value from the second table based on a temperature measurement and the desired transmit frequency, using bilinear interpolation. This calculates the net effect of transmit frequency and temperature. In step 40, the terminal adds the two values to form an estimate of the link quality. In step 42, it then compares the computed link quality to threshold values for each code, and in step 44 codes below the threshold are discarded. The final selection of the code to be used is application- and situation-dependent.

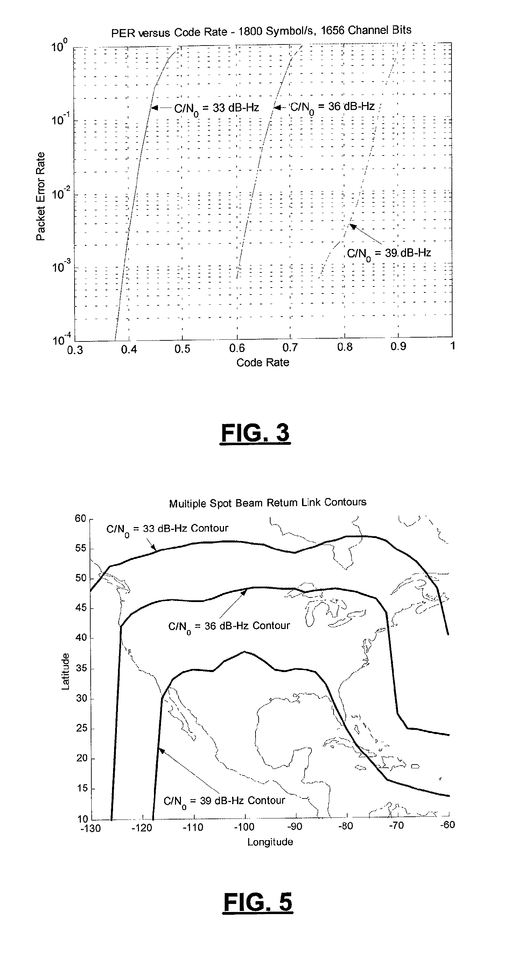

As an example of this embodiment, the link might utilize 460 millisecond burst 1800 symbol per second OQPSK modulation with parallel-concatenated (turbo) coding. The discrete codes would be formed by selection of code rates for each discrete link C/N0 based on a target maximum error rate. For example with reference to Figure 3, with quantization of code rates to three steps at C/N0s of 33, 36 and 39 dB-Hz and a maximum target packet error rate of 1%, the required code rates can be seen to be approximately 0.41, 0.63 and 0.83 respectively. The resulting payload bits per packet are listed in Table 1 for packets with 1656 channel bits.

| C/N0 | Code Rate | Info Bits |
|---|---|---|
| 33 | 0.41 | 679 |
| 36 | 0.63 | 1043 |
| 39 | 0.83 | 1374 |

Once the code rates are determined, specific interleavers and puncturing matrices can be designated for each code based on constant length, constant symbol rate transmit bursts. The interleavers and puncturing matrices can be stored in both the remote terminal and central hub for encoding and decoding of data. The remote terminal determines its position as often as required, based on an onboard GPS receiver or other means. It also determines its operating beam, based on multibeam forward link sampling or on position. Before each transmission, it performs the algorithm laid out in Figure 2. It then chooses the transmit code based on the amount of data to be transmitted. If the amount of data is large than that which is compatible with a single burst at the highest code rate, then the remote terminal chooses the highest rate code and transmits the data as multiple bursts. Otherwise, the terminal selects the lowest rate code compatible with transmission of the data in a single burst.

In the central hub, the code utilized for the burst can be detected by various means. One technique is to attach format information as part of the transmit burst, with separate encoding from the rest of the data or with transmission at a lower rate. For example, a linear block code could be used, designed for a sufficiently low error rate at the minimum link C/N0. Another technique for code detection could use encapsulation of a cyclic redundancy check or checksum within the data to be coded. The central hub could decode the received burst using each of the possible codes, and discard any packet with an incorrect CRC or checksum.

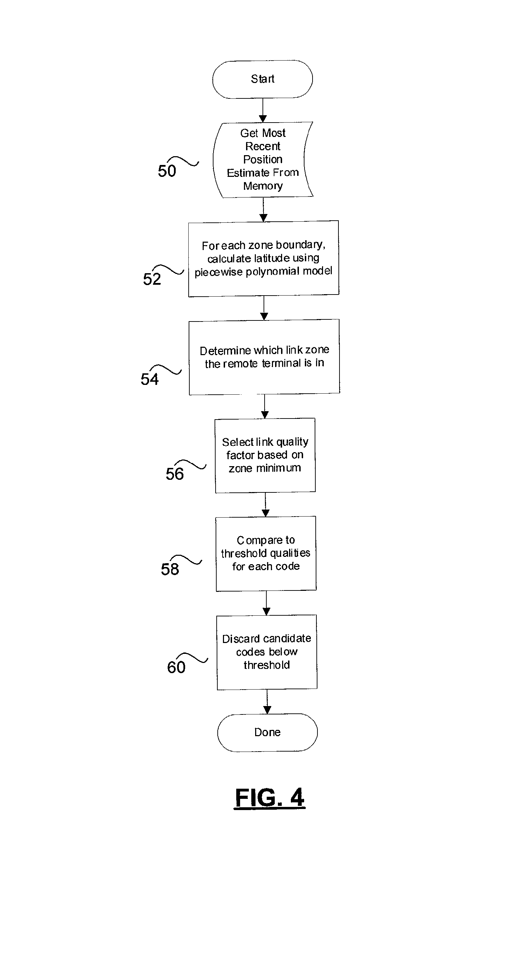

Figure 4 shows a flowchart for a second method of rate adaptation, which is similar to the method of Figure 2 except that only position-based link compensation is performed. In step 50, the most recent position estimate from memory is obtained. In step 52, latitude is calculated for each zone boundary using piecewise polynomial model. In step 54, the link that the remote terminal is in is determined. In step 56, the link quality factor is selected based on zone minimum. In step 58, the threshold qualities for each code are compared. In step 60, the candidate codes below threshold are descended.

The potential advantage of this second method is reduction of data storage within the remote terminal. With this simplification, instead of storing tabular data in the remote terminal the divisions between link quality zones are predetermined and encoded in mathematical form (e.g. a set of piecewise polynomials in longitude, giving the latitude at which each zone boundary is placed).

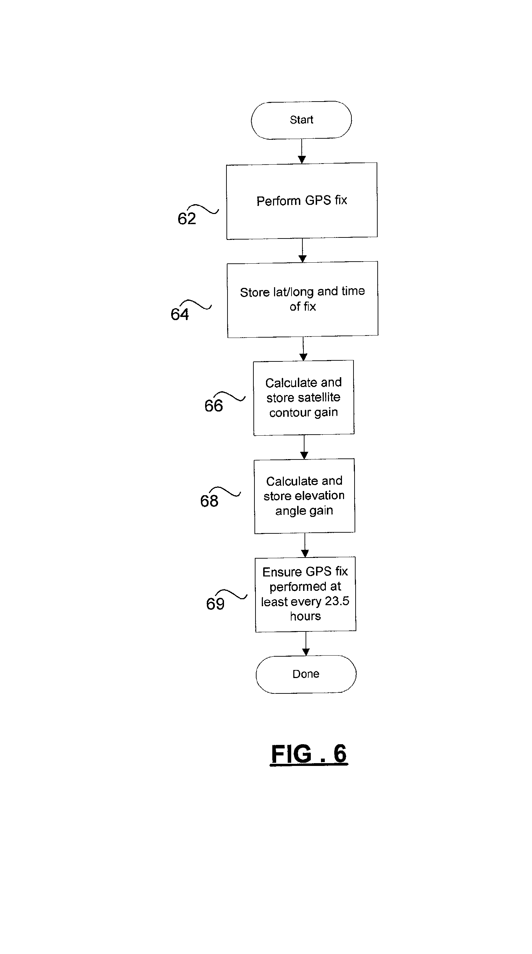

As an example of this embodiment, the codes and transmission method of the previous example could be used. Figure 5 shows the zone divisions for a hypothetical multibeam satellite, as link budget contours inclusive of terminal and satellite antenna gain factors and path loss as well as margin. The satellite receive gain for a multibeam satellite is computed as the maximum gain over all beams.

The zone boundaries can then be modeled using piecewise polynomials. Using its position, the remote terminal would determine which zone it was in using the mathematical models of the boundaries. Based on this, it would perform code selection as in the previous embodiment.

A rate adjustment method according to this invention may maximize the variable information rate for a fixed bandwidth utilization, for different user areas within a satellite beam. Existing systems utilize a constant information rate corresponding to an acceptable C/No for the user at edge of coverage. In particular, the predicted C/No ratio for the location of the mobile unit is determined and the number of extra bits in the FEC are selected to ensure an acceptable data throughput at predicted ration. Typically, the FEC will be set slightly above the minimum threshold to allow for a small margin of error.

In another aspect, power adaptation method is employed. The open loop implementation of this aspect compensates for terminal position (satellite gain contours) and satellite elevation angle. Gains associated with open loop compensation need only be computed after each GPS fix.

The terminal must know its position to a low but non-zero degree of accuracy (for example, the grid spacings for Europe 1100 km at the equator). Based on the low-mobility assumption, the position of the terminal is assumed to be correlated over a day and fixes need not be taken more often, or if highly mobile will be movement-tracked by the customer. Figure 6 is a flowchart illustrating an open loop method. When the terminal performs a GPS fix in step 62, the latitude/longitude and time of fix (as determined by the onboard RTC) are stored in step 64. The satellite contour gain and elevation angle gain, both of which are described below, are calculated and stored in steps 66 and 68, respectively. The GPS fixes are performed approximately at least every 23.5 hours on all terminals in step 69. GPS fix intervals of 24 hours are unfavored as the satellite constellation approximately repeats on this interval. This could give rise to sustained periods of poorer fix time performance for a small number of terminals.

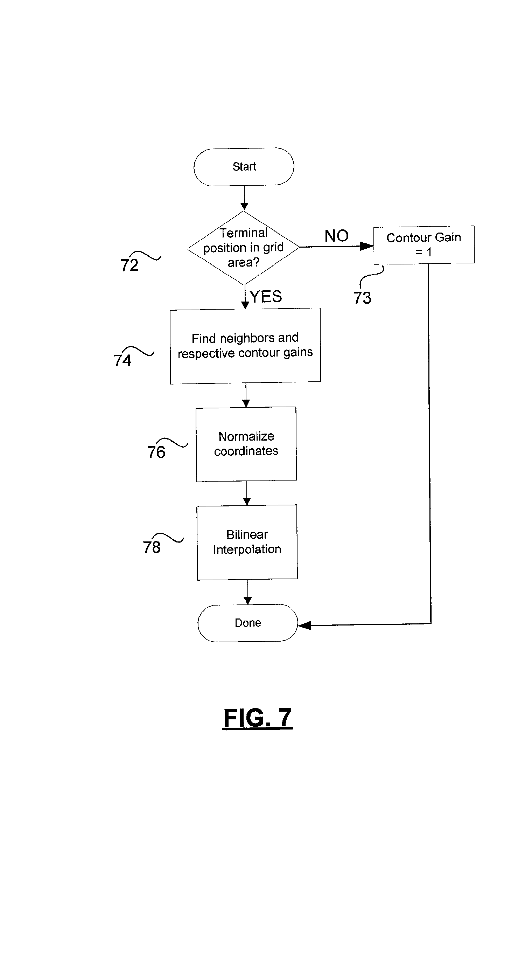

Any suitable technique for compensation of the satellite gain may be used. One such method is described and illustrated in Figure 7 as an example. In this method, *lat* and *lon* are the terminal's current latitude/longitude, *la1* and *la2* are the nearest-neighbour latitudes in the stored grid such that *la1≤lat≤la2,* and *lo1* and *lo2* are the nearest-neighbour longitudes in the stored grid such that *lo1≤lon≤lo2.* In step 72, it is determined whether the terminal position falls within the area defined by the stored grid. If not, in step 73 the contour gain is set to 1.0 and no other steps are required. Otherwise, in step 74, find the nearest neighbours in the stored grid (*la1*, *la2*, *lo1*, *lo2*) and their respective stored contour gains g(*la1, lo1*), g(*la1, lo2*), g(*la2,lo2*) are found. Then the normalized coordinates of the terminal within the grid rectangle are found in step 76:

$$t= (lat\text{-}la1)/(la2\text{-}la1)$$

; and

$$u = (lon\text{-}lo1)/(lo2\text{-}lo1).$$

Finally in step 78, bilinear interpolation is performed to calculate the resultant satellite contour gain:

$$SCG= (1\text{-}t)(1\text{-}u)g(la1,lo1) +t(1\text{-}u)g(la2,lo1) + tug(la2,lo2) + (1\text{-}t)ug(la1,lo2)$$

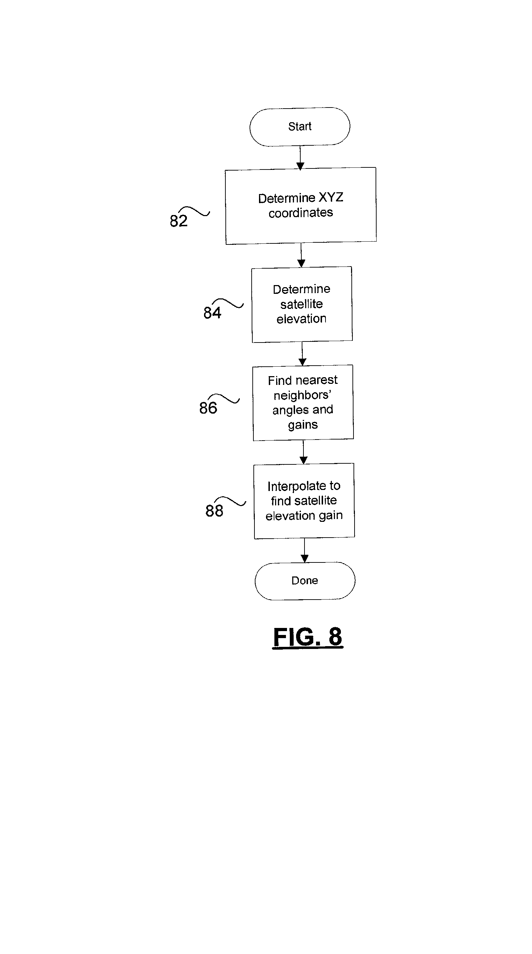

Any suitable technique for compensation of the terminal EIRP variation due to satellite elevation angle may be used. One such method is described below and illustrated in Figure 8. First in step 82, the terminal XYZ Earth-centred, Earth-fixed coordinates in kilometers are determined as follows

$$TrmX = 6367.0 * cos(DEG2RAD * lat) * cos(DEG2RAD * lon);$$

$$TrmY = 6367.0 * cos(DEG2RAD * lat) * sin(DEG2RAD * lon);$$

$$TrmZ = 6367.0 * sin(DEG2RAD * lat);$$

Then in step 84, the satellite elevation angle is determined in degrees:

$$DiffX = SatX\text{-}TrmX;$$

$$DiffY = SatY\text{-}TrmY;$$

$$Num = DiffX*TrmX+DiffY*TrmY\text{-}TrmZ*TrmZ;$$

$$Denom = sqrt((DiffX2+DiffY2+TrmZ2) * (TrmX2 + TrmY2 + TrmZ2));$$

$$Elev = RAD2DEG * asin(Num/Denom);$$

$$(Note: RAD2DEG = 180/\Pi).$$

Then in step 86, using a table of antenna gains versus elevation angle stored in flash, the nearest-neighbour angles and corresponding gains are found. Finally in step 88, the satellite elevation gain is found by interpolation. It should be noted that the spherical-earth approximation used above gives rise to no more than 0.2° elevation angle error, which is negligible.

A closed loop implementation of improving the efficiency in a satellite communications system using a long time constant may also be used. In this method, if the Earth station continuously received transmissions of poor quality over a period of time, the Earth station begins determining the rate on a predicted basis. Over time, the Earth station transmits a message to adjust various transmission parameters that will improve either the transmission rate or power. In this way, the system operated in a predictive mode to improve the rate or power of future transmissions.

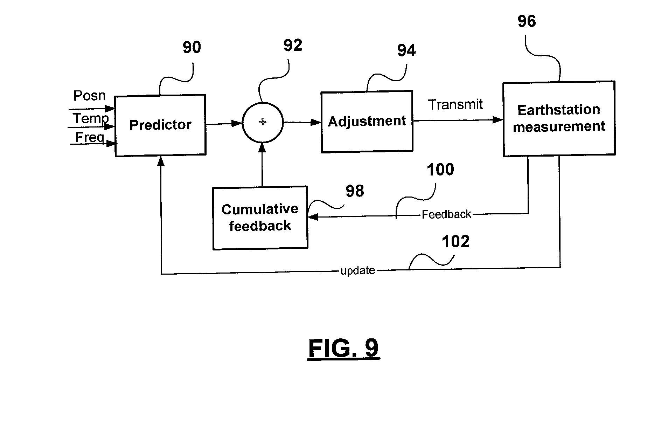

Figure 9 illustrates such a system. The predictor 90 predicts the quality of the return link on based on the position of the terminal, determined from an on-board GPS receiver, temperature, and frequency of the transmission. The output of the predictor is used by adjustment unit 94 to change the transmit power or effective transmission rate based on the predicted quality of the return link.

The system can function in an open-loop mode as described thus far. However, it may be desirable to include a slow feedback loop 100 and cumulative feedback unit 98, which adjusts the output of the predictor according to the strength of the transmissions received by the earthstation 96. The feedback loop has a long time constant so that the transmission characteristic is only adjusted from the predicted value if over a period of time the transmission quality is inadequate and too many retransmissions occur.

In addition to the per-terminal feedback loop 100, it is possible to provide an update path 102. This can be used to update stored threshold values in the predictor 90, which it uses to determine link quality. Typically, and update would occur on a system-wide basis to change the threshold values of all the terminals on the system. The feedback and update signals are transmitted in packets on the forward link.

For open-loop power control over path 102, information is disseminated to the terminals via part 2 of a bulletin board. The general format for part 2 of the bulletin board is:

| Number of bits | Data Bit | Description |
|---|---|---|
| 7 | 1-7 | Bulletin Board Part 2 Packet Type (124) |
| 1 | 8 | Reserved (zero) |
| 8 | 9-16 | Sub-Type |
| 464 | 17-480 | Sub-Type Specific Data |
| 16 | 481-496 | CRC |
| 4 | 497-500 | Reserved (zero) |

| Sub-Type | Description |
|---|---|
| 0 | GPS Almanac |
| 1 | Power Control |

(continued)

| Sub-Type | Description |
|---|---|
| 2-255 | Reserved |

This leaves 464 bits which can be used to broadcast satellite characteristics to the terminals. The satellite beam is characterized by a grid of gains versus latitude and longitude, with ancillary data required by the terminal. The broadcast power control bulletin board will contain the following sub-type specific data, in order:

| Field # | Name | # bits | Format | Comment |
|---|---|---|---|---|
| 1 | ESE Channel (satellite ID) | 3 | Unsigned int | |
| 2 | Beam Number | 3 | Unsigned int | |
| 3 | Control On/off | 1 | Boolean | 1 = implement power control |
| 4 | Sequence Number | 1 | Unsigned | Toggle every time the BB content changes |
| 5 | Satellite longitude | 10 | Signed int | half-degrees |
| 6 | # of grid latitudes | 3 | Unsigned int | Add 1 to get the actual number |
| 7 | # of grid longitudes | 3 | Unsigned int | Add 1 to get the actual number |
| 8 | First latitude | 8 | Signed int | Degrees |
| 9 | Last latitude | 8 | Signed int | Degrees |
| 10 | First longitude | 9 | Signed int | Degrees |
| 11 | Last longitude | 9 | Signed int | Degrees |
| 12 | Reserved | 15 | | Set to all zeros |
| 13 | Gain offset | 7 | Signed int | eighths of a dB |
| 14+ | Gain data | 6 | Signed int | eighths of a dB |

The number of grid latitudes/longitudes is 1 to 8, expressed as 0 to 7.

The gain data is to be broadcast in a grid. The data will be organized in rows (latitude) and columns (longitude). The data will be transmitted by rows (for example, if the table was 2x3, the order of the transmitted data would be lat1/lon1, lat1/lon2, lat1/lon3, lat2/lon1, lat2/lon2, lat2/lon3). The signed 6-bit format in units of eighths of a dB means that gains from -4 to +3.875 can be expressed. The number will be interpreted as an excess gain that must be compensated for; a positive number will result (all other things being equal) in a reduction of the terminal's transmitted power.

The latitudes and longitudes must be ordered least to greatest (first latitude < last latitude, first longitude < last longitude). The first gain data to be transmitted is that at the lowest latitude and longitude. Latitudes and longitudes will be expressed as positive degrees North/degrees East; the longitude range will be ±180° rather than 0-360°.

The gain values to be transmitted could be expressed in logarithmic (dB) or linear format. As the range of gains is fairly small, linear gains would be best expressed as offsets from a nominal gain to maximize utilization of the bits. Logarithmic expression was chosen as it meets this aim and has the added benefits of familiarity and ease of use.

At the earthstation 96, the return link subframe message from the Earthstation 96 to the packet processing and network operations center 12 (PPC) should be modified. To provide power measurements to the PPC, the earthstation appends a 2-byte integer to each packet containing the demodulator-measured packet power.

To provide power control information back to the terminal, the forward link ACK message from the PPC 12 to the MT (packet type 125) content should be modified. In addition to the replied packet type, two additional bits can be included as bits 7 and 8 of the forward link ACK packet data. In each ACK received from the PPC 12, the terminal should receive 10 data bits. The terminal examines bits 7 and 8 of the data and act as follows:

If bit 7 is 0, do nothing,
If bit 7 is 1 and bit 8 is 0, multiply the current gain by 0.988553 (-0.1 dB). If the gain is less than [0.25], set it to [0.25],
If bit 7 is 1 and bit 8 is 1, multiply the current gain by 1.011579 (0.1 dB). If the gain is greater than [4], set it to [4].

It has been assumed that only one power control bulletin board will be used at any time. There is no reason to preclude the storage by the terminal of bulletin board power control information for multiple beams.
There is also no reason to preclude the terminal from having a closed-loop gain for each beam; the assumption is made here.
Numerous modifications may be made without departing from the spirit and scope of the invention as defined in the appended claims.

**Claims**

1.  A method of improving efficiency in a digital satellite communications system, **characterized in that** it comprises:

    predicting the quality of a return link from a remote terminal to a central station from one or more parameters known at the remote terminal;
    determining an appropriate transmission characteristic for said return link based on said predicted quality; and
    adjusting an actual transmission characteristic of said return link to match said appropriate transmission characteristic.

2.  A method as claimed in claim 1, **characterised in that** said one or more known parameters include the position of the remote terminal.

3.  A method as claimed in claim 2, **characterised in that** said appropriate transmission characteristic is computed in accordance with a predetermined formula.

4.  A method as claimed in claim 2, **characterised in that** said appropriate transmission characteristic is read out from a look-up table storing appropriate transmission characteristics for different parameters.

5.  A method as claimed in claim 2, **characterised in that** said transmission characteristic is determined from the elevation angle from the remote terminal to the satellite.

6.  A method as claimed in claim 1, **characterised in that** said transmission characteristic comprises the effective transmission rate.

7.  A method as claimed in claim 1, **characterised in that** said transmission characteristic is the transmitted power.

8.  A method as claimed in claim 7, the transmitted power is reduced to a value that just provides sufficient signal-to-noise ratio for the desired effective transmission rate so as to optimize system capacity.

9.  A method as claimed in claim 6, **characterised in that** an appropriate forward error correcting code (FEC) for encoding transmitted data is selected to match the effective actual transmission rate to the determined appropriate transmission rate for said return link.

10. A method as claimed in claim 9, **characterised in that** format information identifying the selected forward error correcting code is attached to said transmitted data.

11. A method as claimed in claim 1, **characterised in that** said one or more parameters also include available terminal transmit power.

12. A method as claimed in claim 11, **characterised in that** said available transmit power is determined by taking into account one or more parameters selected from the group consisting of: temperature, frequency and aging effects on said remote terminal.

13. A method as claimed in claim 1, **characterised in that** the quality of the return link is predicted based on stored values, and said stored values are periodically updated in accordance with the quality of signals received at said central station.

**14.** A method as claimed in claim 1, **characterised in that** it further comprises a slow feedback loop for modifying said predicted quality of a terminal according to the strength of received signals.

**15.** An apparatus for improving efficiency in a two-way wireless digital communications system, **characterized in that** it comprises:

a predictor for predicting the quality of a return link from a remote terminal to a central station from one or more parameters known at the remote terminal;
a processor for determining an appropriate transmission characteristic for said return link based on said predicted quality; and
an adjustor for adjusting an actual transmission characteristic of said return link to match said appropriate transmission characteristic.

**16.** An apparatus as claimed in claim 15, **characterised in that** said one or more known parameters include the position of the remote terminal.

**17.** An apparatus as claimed in claim 16, **characterised in that** said processor computes said appropriate transmission characteristic in accordance with a predetermined formula.

**18.** An apparatus as claimed in claim 16, **characterised in that** said processor reads said appropriate transmission characteristic out from a look-up table storing appropriate transmission characteristics for different parameters.

**19.** An apparatus as claimed in claim 16, **characterised in that** processor determines said transmission characteristic from the elevation angle from the remote terminal to the satellite.

**20.** An apparatus as claimed in any one of claims 16 to 19, **characterised in that** said transmission characteristic comprises the effective transmission rate.

**21.** An apparatus as claimed in any one of claims 16 to 19, **characterised in that** said transmission characteristic is the transmitted power.

**22.** An apparatus as claimed in claim 20, **characterised in that** said processor selects an appropriate forward error correcting code (FEC) for encoding transmitted data is selected to match the effective actual transmission rate to the determined appropriate transmission rate for said return link.

**23.** An apparatus as claimed in claim 22, **characterised in that** said processor attaches format information for identifying the selected forward error correcting code to said transmitted data.

**24.** An apparatus as claimed in claim 15, **characterised in that** said one or more parameters also include available terminal transmit power.

**25.** An apparatus as claimed in claim 24, **characterised in that** said available transmit power is determined by taking into account a parameter selected from the group consisting of: temperature, frequency and aging effects on said remote terminal.

**26.** An apparatus as claimed in claim 15, **characterised in that** said predictor predicts the quality of the return link based on stored values, and said stored values are periodically updated in accordance with the quality of signals received at said central station.

**27.** An apparatus as claimed in claim 15, further comprising a feedback loop with a long time constant for modifying said predicted quality of a terminal based on the strength of received signals.

**28.** An apparatus as claimed in claim 27, further comprising cumulative feedback unit in said feedback loop for accumulating feedback information for a terminal.

11

16

17

15

18

19

19

20

12 Packet processing and network operations

13 User applications

10

**FIG. 1**

**FIG. 2**

PER versus Code Rate - 1800 Symbol/s, 1656 Channel Bits

**FIG. 3**

Multiple Spot Beam Return Link Contours

**FIG. 5**

Start

50 — Get Most Recent Position Estimate From Memory

52 — For each zone boundary, calculate latitude using piecewise polynomial model

54 — Determine which link zone the remote terminal is in

56 — Select link quality factor based on zone minimum

58 — Compare to threshold qualities for each code

60 — Discard candidate codes below threshold

Done

**FIG. 4**

Start

62 Perform GPS fix

64 Store lat/long and time of fix

66 Calculate and store satellite contour gain

68 Calculate and store elevation angle gain

69 Ensure GPS fix performed at least every 23.5 hours

Done

**FIG . 6**

```
                    ┌─────────────┐
                    │    Start    │
                    └──────┬──────┘
                           │
                           ▼
                      ╱─────────╲
                    ╱  Terminal   ╲          NO        ┌─────────────┐
        72        ╱ position in grid ╲────────────────▶│ Contour Gain │
                  ╲     area?      ╱                    │    = 1       │
                    ╲           ╱                       └──────┬──────┘
                      ╲───────╱                   73           │
                           │                                   │
                          YES                                  │
                           ▼                                   │
                 ┌──────────────────────┐                      │
                 │  Find neighbors and  │                      │
        74       │ respective contour   │                      │
                 │       gains          │                      │
                 └──────────┬───────────┘                      │
                            │                                  │
                            ▼                                  │
                 ┌──────────────────────┐                      │
                 │                      │                      │
        76       │     Normalize        │                      │
                 │    coordinates       │                      │
                 └──────────┬───────────┘                      │
                            │                                  │
                            ▼                                  │
                 ┌──────────────────────┐                      │
                 │                      │                      │
        78       │     Bilinear         │                      │
                 │   Interpolation      │                      │
                 └──────────┬───────────┘                      │
                            │                                  │
                            ▼                                  │
                    ┌─────────────┐                            │
                    │    Done     │◀───────────────────────────┘
                    └─────────────┘
```

## FIG. 7

Start

Determine XYZ
coordinates
82

Determine
satellite
elevation
84

Find nearest
neighbors'
angles and
gains
86

Interpolate to
find satellite
elevation gain
88

Done

## FIG. 8

**FIG. 9**